# EUROPÄISCHE PATENTSCHRIFT

(11) **EP 0 296 380 B1**
(45) Veröffentlichungstag und Bekanntmachung des Hinweises auf die Patenterteilung: **05.01.1994**
(21) Anmeldenummer: 88108590.6
(22) Anmeldetag: 30.05.1988
(51) Int. Cl.: H01L 39/12, H01L 39/24, C04B 35/00

(54) **Verfahren zur Erhöhung der kritischen Stromdichte in Supraleitern auf Kupferoxid-Basis**
Method of enhancing the critical current density of copper-based superconductors
Méthode pour augmenter la densité de courant critique dans les supra-conducteurs à base d'oxyde de cuivre

(30) Priorität: 23.06.1987 DE 3720678
(43) Veröffentlichungstag der Anmeldung: 28.12.1988
(73) Patentinhaber: Vacuumschmelze GmbH, 63450 Hanau (DE)
(72) Erfinder: Hillmann, Hans, Dr., D-6454 Bruchköbel (DE); Szulczyk, Andreas, D-6464 Linsengericht 5 (DE)

(56) Entgegenhaltungen:
- EP-A- 0 292 126
- EP-A- 0 303 813
- US-A- 3 447 913
- US-A- 4 264 358
- JAPANESE JOURNAL OF APPLIED PHYSICS/Teil 2: LETTERS, Band 26, Nr. 6, 20. Juni 1987, Seiten L1019-L1020, Tokyo, JP; R. ESCUDERO et al.: "Superconductivity at 90 K in the Y-Ba-Al-Cu-O system"
- PHYSICAL REVIEW LETTERS, Band 58, Nr. 18, 4. Mai 1987, Seiten 1888-1890, The American Physical Society; D.W. MURPHY et al.: "New superconducting cuprate perovskites"
- JAPANESE JOURNAL OF APPLIED PHYSICS, Band 26, Nr. 5, 20. Mai 1987, Teil 2, Seiten L704-L705, Tokyo, JP; S. TSURUMI et al.: "High-Tc superconductivities of (Y1-xYbx)2Ba4Cu6O14+y(O y 2.5)"
- PATENT ABSTRACTS OF JAPAN, Band 13, Nr. 137 (C-582)[3485], 5. April 1989 & JP-A-63 303 849 (THE FURUKAWA ELECTRIC CO. LTD) 12-12-1988
- PROCEEDINGS OF THE INTERNATIONAL WORKSHOP ON NOVEL MECHNISMS OF SUPERCONDUCTIVITY, Berkeley, CA, 22.-26. Juni 1987, Seiten 801-805, Plenum 1987, New York, US; K. NOTO et al.: "Current carrying properties in high Tc Y-Ba-Cu-O system"
- APPL. PHYS. LETT, Band 52, Nr. 17, 25. April 1988, Seiten 1447-1448, American Institute of Physics; P.V.P.S.S. SASTRY et al.: "Enhancement of transport critical current density by Gd substitution in YBa2Cu3O7"
- J. Am. Chem. Soc., Bd. 109, Nr. 9, 29. April 1987, SEiten 2848-2849; E.M. Engler et al.: "Superconductivity above liquid nitrogen temperature: Preparation and properties of a Family of Perowskite based superconductors"

## Beschreibung

Die Erfindung betrifft ein Verfahren zur Erhöhung der kritischen Stromdichte in Supraleitern auf Kupferoxid-Basis.

Supraleiter auf Metalloxid-Basis mit "Perovskite-Gitter" weisen bekanntlich Sprungtemperaturen auf, die über der Temperatur des flüssigen Stickstoffs liegen. Sie sind daher für die Herstellung technischer Supraleiter für die Energieübertragung und die Erzeugung hoher Magnetfelder besonders interessant. Supraleiter auf Kupferoxid-Basis sind bekannt in der Zusammensetzung

La₍ₗ₋ₓ₎ CuO₄ + Ba_{0,15 - 0,2}

wobei Sr oder Ca oder Y für La eingesetzt werden kann. Die Herstellung des supraleitenden Materials erfolgt hierbei durch intensives Mischen entsprechender oxidischer Pulver mit anschließendem Pressen und Sintern in Sauerstoff-Atmosphäre.

Für Supraleiteranwendungen, wie z. B. für den verlustfreien Stromtransport und zum Bau supraleitender Magnetspulen werden folgende physikalische Eigenschaften des supraleitenden Materials vorausgesetzt:
1. hohe Sprungtemperatur
2. hohes kritisches Magnetfeld,
3. hohe kritische Stromdichte.

Die beiden ersten Eigenschaften, nämlich hohe Sprungtemperatur und hohes kritisches Magnetfeld sind bei Supraleitern auf Kupferoxid-Basis besonders günstig, da sie von der chemischen Zusammensetzung bestimmt werden. Hingegen ist die kritische Stromdichte derartiger Supraleiter sehr niedrig, so daß die technische Anwendung der bisher bekannten Supraleiter auf Kupferoxid-Basis noch nicht gerechtfertigt ist.

Die Patentschrift US-A-3447913 beschreibt ein Verfahren zur Erhöhung der kritischen Stromdichte in klassischen Supraleitern durch Erzeugung von Aluminiumoxid- oder Titanoxid-Einschlüssen geeigneter (der Kohärenzlänge des Supraleiters entsprechender) Größe in der supraleitenden Matrix.

Die nach Artikel 54 (3) EPÜ zum Stand der Technik zählende Europäische Anmeldung EP-A-0292126 beschreibt ein Verfahren zur Erhöhung der kritischen Stromdichte in Supraleitern auf Kupferoxid-Basis durch Einbringen fein verteilter Metallteilchen (Ag, Au, Al, etc.) in die supraleitende Matrix, wobei die als Haftzentren dienenden Metallteilchen direkt in Metallpulverform oder in Form zersetzbarer Metallverbindungen (Oxide, Carbide, etc.) zugemischt werden.

Der Erfindung liegt die Aufgabe zugrunde, ein Verfahren zu schaffen, mit dem die kritische Stromdichte in Supraleitern auf Kupferoxid-Basis erhöht werden kann. Gelöst wird diese Aufgabe durch ein Verfahren, wie es im Patentanspruch 1 näher beschrieben ist. Der Erfindung liegt dabei die Erkenntnis zugrunde, daß die kritische Stromtragfähigkeit von Störungen im inneren Aufbau, nämlich von sogenannten Haft- oder Pinningzentren bestimmt wird. Dadurch, daß gemäß der Erfindung nicht-supraleitende Magnesiumoxid- und/oder Lithiumoxid-Teilchen in einer für die Haftwirkung optimalen Größe eingebaut werden, ohne den für die Supraleitung verantwortlichen Kristallgittertyp zu beeinträchtigen oder zu verunreinigen, können den Leiter durchdringende Magnetflußlinien durch Energieabsenkung an den oxidischen Partikeln festgehalten (gepinnt) werden, ohne daß Sprungtemperatur und kritisches Magnetfeld beeinträchtigt werden.

Durch die erfindungsgemäße Bildung von sogenannten Haftzentren wird also für die gute Flußlinienverankerung gesorgt, welche Voraussetzung dafür ist, daß im Magnetfeld auch hohe kritische Ströme ermöglicht werden. Zur Erreichung hoher kritischer Ströme werden daher in den Supraleiter nicht-supraleitende Bereiche mit einer Ausdehnung in der Größenordnung der supraleitenden Kohärenzlänge (ca. 20 nm) und mit einer Dichte von mindestens 10¹⁵ pro cm³ eingebracht. Derartige Haftzentren können Leerstellen-Versetzungsagglomerate, Ausscheidungen oder normalleitende Partikel sein, in denen die durch sie durchlaufenden Flußfäden ihre Energie absenken können. Beim Einbringen oder Erzeugen derartiger nicht-supraleitender Bereiche darf dabei die supraleitende Matrix durch Aufnahme von Fremdatomen in ihren supraleitenden Eigenschaften nicht beeinflußt werden. Außerdem darf aus dem mit Sauerstoff gesättigten Grundgitter durch Oxidation der Zusatzstoffe der Sauerstoff nicht reduziert werden. Andererseits darf jedoch das nicht mit Sauerstoff gesättigte Grundgitter den Zusatzstoffen Sauerstoff entziehen, ohne jedoch deren metallische Komponenten in das Gitter einzubauen. Die Wahl der geeigneten Zusatzstoffe sowie deren Einbringen in den supraleitenden Grundkörper bilden weiterhin Gegenstand der Erfindung.

Wie bereits ausgeführt, wird das supraleitende Material aus mehreren verschiedenen oxidischen Pulvern durch intensives Mischen, Pressen und Sintern in Sauerstoff-Atmosphäre hergestellt. Bei der Mischung der Pulver werden nicht nur die die Supraleitung bewirkenden Grundkomponenten sondern auch erfindungsgemäße Zusätze im trockenen Zustand beigefügt und einem sorgfältigen Mischungsvorgang unterzogen. Im Falle des Vorliegens metallischer feindisperser Pulver können diese in Sauerstoff- oder Luftatmosphäre beigemengt und sorgfältig gemischt werden. In diesem Falle ist vor dem eigentlichen Sintervorgang ein vorzugsweise vor dem Verpressen in sauerstoffhaltiger Atmosphäre zu erfolgender Oxidationsprozeß durchzuführen. Danach erfolgt das Verpressen der Proben.

Zum Einbringen eignen sich vorzugsweise Stoffe mit einer möglichst hohen negativen freien Bildungsentalpie ihrer Oxide, welche entweder feindispers mit der linearen Ausdehnung von der Größenordnung der supraleitenden Kohärenzlänge von 10 bis 20 nm hergestellt werden können und deren metallischer Bestandteil entweder nicht vom supraleitenden Gitter aufgelöst werden kann oder in schwer auflösbarem Oxid einer der im Supraleiter enthaltenden Komponenten vorliegt. Geeignet sind erfindungsgemäß Mg-Oxid und Li-Oxid.

Wegen der Beeinträchtigung der guten supraleitenden Eigenschaften durch Einbau von Fremdatomen in das Kristallgitter müssen die oxidischen Zusätze in hochreiner Form vorliegen. Der Anteil der normalleitenden Zusätze liegt in der Größenordnung von 0,1 bis 10 %, insbesondere aber zwischen 0,1 bis 1 %. Die Teilchengröße der Matrixstoffe (Supraleiter) wird vorzugsweise kleiner als 200 nm gewählt.

## Patentansprüche

1. Verfahren zur Erhöhung der kritischen Stromdichte in Supraleitern auf Kupferoxid-Basis, wobei aus den pulverförmigen oxidischen Grundkomponenten des Supraleiters unter Zugabe von Magnesiumoxid- und/oder Lithiumoxidteilchen durch intensives Mischen, Pressen und Sintern in Sauerstoffatmosphäre ein supraleitendes Material hergestellt wird, das die nicht-supraleitenden Magnesiumoxid- und/oder Lithiumoxid-Teilchen als Haftzentren für magnetische Flußschläuche in einer für die Haftwirkung optimalen Größe aufweist, ohne daß das supraleitende Grundgitter verunreinigt oder sonst in seinen supraleitenden Eigenschaften beeinträchtigt wird wird.

2. Verfahren nach Anspruch 1, gekennzeichnet durch die Zugabe von Magnesiumoxid - und/oder Lithiumoxidteilchen mit einer linearen Ausdehnung in der Größenordnung der supraleitenden Kohärenzlänge von 10 bis 20 nm.

3. Verfahren nach Anspruch 1 oder 2, dadurch gekennzeichnet, daß der Volumenanteil der zugesetzten Magnesium- und/oder Lithiumteilchen 0,1 bis 10 % beträgt.

4. Verfahren nach einem der vorhergehenden Ansprüche, dadurch gekennzeichnet, daß die Teilchengröße der supraleitenden Matrixstoffe kleiner als 200 nm ist.

## Claims

1. A method of increasing the critical current density in superconductors based on copper oxide, wherein a superconductive material is produced from the powdery oxidic fundamental components of the superconductor with the addition of magnesium oxide- and/or lithium oxide particles by intensive mixing, pressing and sintering in an oxygen atmosphere, which superconductive material comprises the non-superconductive magnesium oxide- and/or lithium oxide particles as traps for magnetic flux lines in a magnitude which is optimal for the trapping effect, without the superconductive fundamental lattice being contaminated or otherwise impaired in respect of its superconductive properties.

2. A method as claimed in Claim 1, characterised by the addition of magnesium oxide- and/or lithium oxide particles with a linear dimension in the order of magnitude of the superconductive coherence length of 10 to 20 nm.

3. A process as claimed in Claim 1 or 2, characterised in that the volume percentage of the added magnesium- and/or lithium particles is 0.1 to 10%.

4. A method as claimed in one of the preceding claims, characterised in that the particle size of the superconductive matrix materials is smaller than 200 nm.

## Revendications

1. Procédé pour augmenter la densité de courant critique dans des supraconducteurs à base d'oxyde de cuivre, dans lequel est produit un matériau supraconducteur à partir des composants de base sous forme de poudre, par voie d'oxydation, du supraconducteur en ajoutant des particules d'oxyde de magnésium et/ou d'oxyde de lithium, par brassage intensif, compression et frittage en atmosphère d'oxygène, matériau qui comporte les particules non supraconductrices d'oxyde de magnésium et/ou d'oxyde de lithium comme centres de captage pour des tubes de flux magnétiques en une grandeur optimale pour l'effet de captage, sans que le réseau de base supraconducteur ne soit contaminé ou en outre ne soit affecté dans ses propriétés supraconductrices.

2. Procédé selon la revendication 1,
caractérisé par l'addition de particules d'oxyde de magnésium et/ou d'oxyde de lithium avec son extension linéaire de l'ordre de grandeur de la longueur de cohérence supraconductrice de 10 à 20 nm.

3. Procédé selon la revendication 1 ou 2,
caractérisé en ce que la quote-part de volume des particules de magnésium et/ou de lithium ajoutées se situe entre 0,1 et 10%.

4. Procédé selon une des revendications précédentes,
caractérisé en ce que la grandeur des particules des matières de la matrice supraconductrice est inférieure à 200 nm.
